# EUROPEAN PATENT APPLICATION

(11) **EP 4 195 269 A1**
(43) Date of publication of application: **14.06.2023**
(21) Application number: 21820446.9
(22) Date of filing: 09.02.2021
(51) Int. Cl.: H01L 27/02, H01L 23/60

(54) **ELECTROSTATIC PROTECTION DEVICE FOR SEMICONDUCTOR**

(30) Priority: 06.08.2020 CN 202010780889
(71) Applicant: Changxin Memory Technologies, Inc., Hefei, Anhui 230601 (CN)
(72) Inventor: XU, Qi'an, Hefei, Anhui 230000 (CN)
(74) Representative: Lavoix
(86) International application number: PCT/CN2021/076271
(87) International publication number: WO 2022/027952

(57) **Abstract**

The present invention relates to a semiconductor electrostatic protection device, including: a substrate, a deep well region of a first conductivity type being formed in the substrate; a first diode, an anode of the first diode being connected to a first voltage, and a cathode of the first diode being connected to an input/output terminal; and a second diode, an anode of the second diode being connected to the input/output terminal, and a cathode of the second diode being connected to a second voltage; the first diode and the second diode being located in the deep well region of the first conductivity type.

## Description

### CROSS-REFERENCE TO RELATED APPLICATION

This application claims priority to Chinese Patent Application No. 202010780889.5, entitled "SEMICONDUCTOR ELECTROSTATIC PROTECTION DEVICE" and filed on August 6, 2020, the entire contents of which are incorporated herein by reference.

### FILED OF THE INVENTION

The present invention relates to a semiconductor electrostatic protection device.

### BACKGROUND OF THE INVENTION

As semiconductor manufacturing processes are becoming increasingly advanced, semiconductor devices are getting smaller, with smaller junction depths and thinner oxide layers, and electrostatic protection devices face an increasingly greater challenge in terms of reliability.

### SUMMARY OF THE INVENTION

According to various embodiments, the present application provides a semiconductor electrostatic protection device, including:
a substrate, a deep well region of a first conductivity type being formed in the substrate;
a first diode, an anode of the first diode being connected to a first voltage, and a cathode of the first diode being connected to an input/output terminal; and
a second diode, an anode of the second diode being connected to the input/output terminal, and a cathode of the second diode being connected to a second voltage;
the first diode and the second diode being located in the deep well region of the first conductivity type.

Details of one or more embodiments of the present application are set forth in the following accompanying drawings and descriptions. Other features and advantages of the present application become obvious with reference to the specification, the accompanying drawings, and the claims.

### BRIEF DESCRIPTION OF THE DRAWINGS

In order to more clearly illustrate the technical solutions in embodiments of the present application, the accompanying drawings used in the description of the embodiments will be briefly introduced below. It is apparent that, the accompanying drawings in the following description are only some embodiments of the present application, and other drawings can be obtained by those of ordinary skill in the art from the provided drawings without creative efforts.
Figure 1 is a top view of a semiconductor electrostatic protection device according to an embodiment of the present invention;
Figure 2 is a schematic structural diagram of a cross-section taken along direction AA' in Figure 1;
Figure 3 is a top view of a semiconductor electrostatic protection device according to another embodiment of the present invention; and
Figure 4 is a schematic cross-sectional structural diagram of a semiconductor electrostatic protection device according to yet another embodiment of the present invention.

Reference numerals: 10: substrate; 12: deep well region; 13: guard ring; 14: doped well region of a first conductivity type; 15: doped well region of a second conductivity type; 16: shallow trench isolation structure; 20: first diode; 201: first doped region; 202: second doped region; 21: second diode; 211: third doped region; 212: fourth doped region; 22: fifth doped region.

### DETAILED DESCRIPTION OF THE EMBODIMENTS

At present, a dynamic random access memory operates faster and faster, which requires an I/O interface not only to have reliable electrostatic protection capability, but also to have relatively small parasitic capacitance. It is increasingly more difficult for the parasitic capacitance of electrostatic protection devices in the prior art to meet such requirements.

For easy understanding of the present invention, a more comprehensive description of the present invention will be given below with reference to the relevant accompanying drawings. Preferred embodiments of the present invention are given in the drawings. However, the present invention may be implemented in many different forms and is not limited to the embodiments described herein. Rather, these embodiments are provided to make the contents disclosed in the present invention more thorough and comprehensive.

Unless defined otherwise, all technical and scientific terms used herein have the same meanings as are commonly understood by those skilled in the art. The terms used herein in the specification of the present invention are for the purpose of describing specific embodiments only but not intended to limit the present invention. The term "and/or" used herein includes any and all combinations of one or more related listed items.

In the description of the present invention, it should be understood that the orientation or position relationship indicated by the terms "upper", "lower", "vertical", "horizontal", "inner", "outer", or the like. are based on the orientation or position relationship shown in the accompanying drawings and are intended to facilitate the description of the present invention and simplify the description only, rather than indicating or implying that the apparatus or element referred to must have a particular orientation or be constructed and operated in a particular orientation, and therefore are not to be interpreted as limiting the present invention.

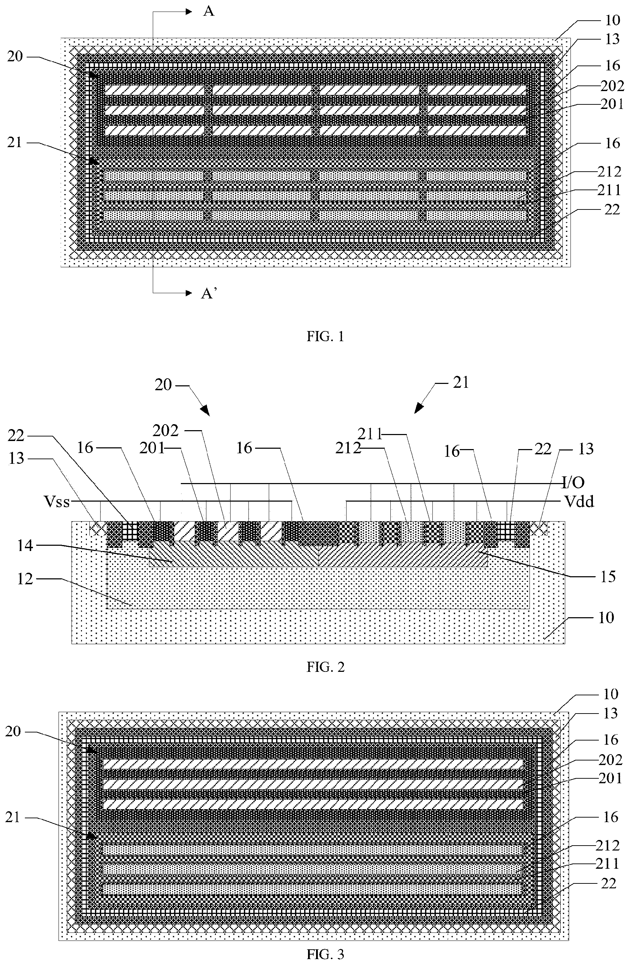

In order that an interface circuit has relatively small parasitic capacitance under a precondition of having good electrostatic protection performance, as shown in Figure 1 and Figure 2, the present invention provides a semiconductor electrostatic protection device, including: a substrate 10, a deep well region 12 of a first conductivity type being formed in the substrate 10; a first diode 20, an anode of the first diode 20 being connected to a first voltage, and a cathode of the first diode 20 being connected to an input/output terminal; and a second diode 21, an anode of the second diode 21 being connected to the input/output terminal, and a cathode of the second diode 21 being connected to a second voltage. The first diode 20 and the second diode 21 are located in the deep well region 12 of the first conductivity type.

In the first diode 20, the anode is connected to the first voltage and the cathode is connected to the input/output terminal, and in the second diode 21, the anode is connected to the input/output terminal and the cathode is connected to the second voltage. Therefore, when a chip is in an electrostatic environment, a transient electrostatic charge may enter an interface circuit of the chip through an input/output pin. When a voltage generated by the electrostatic charge entering the chip through the input/output pin is lower than a reverse breakdown voltage or a forward ON voltage of the first diode 20 and the second diode 21, the electrostatic protection device and an internal circuit of the chip may not be damaged. When the voltage generated by the electrostatic charge is higher than the reverse breakdown voltage or the forward ON voltage of the first diode 20 and the second diode 21, the first diode 20 and/or the second diode 21 are/is broken down reversely or turned on forward, and then, the electrostatic charge may be discharged to avoid damages to semiconductor devices inside the chip caused by the electrostatic charge. Since the first diode 20 and the second diode 21 are located in the deep well region 12, the first diode 20 and the second diode 21 are isolated by the deep well region 12, which can avoid mutual interference with other semiconductor devices inside the chip. Moreover, the first diode and the second diode have relatively small capacitance, so the parasitic capacitance of the first and second diodes can also meet increasingly higher requirements of the dynamic random access memory under a precondition of having good electrostatic discharge performance.

In one optional embodiment, the substrate 10 may be made of silicon, germanium, gallium arsenide (GaAs), indium phosphide (InP) or gallium nitride (GaN), or the like. That is, the substrate 10 may be a silicon substrate, a germanium substrate, a GaAs substrate, an InP substrate or a GaN substrate. In this embodiment, the substrate 10 may be a silicon substrate.

In one example, the deep well region 12 may be either an N-type deep well region or a P-type deep well region 12. In one optional embodiment, the deep well region 12 may be an N-type deep well region 12.

In one optional embodiment, a fifth doped region 22 is formed in the deep well region 12, and the fifth doped region 22 is of the first conductivity type, that is, is of the same conductivity type as the deep well region, and may be a P-type heavily doped region. The fifth doped region 22 may serve as a pickup region of the deep well region 12. The fifth doped region 22 is in a shape of a ring, and the first diode 20 and the second doped region 21 are located in the ring formed by the fifth doped region 22.

In one optional embodiment, the first voltage is a power supply voltage Vdd, and the second voltage is a grounding voltage Vss. That is, in the first diode 20, the anode is connected to the power supply terminal and the cathode is connected to the input/output terminal, and in the second diode 21, the anode is connected to the input/output terminal and the cathode is connected to the grounding terminal. Therefore, when static electricity occurs between the input/output terminal and the power supply terminal and the voltage generated by the electrostatic charge is higher than the reverse breakdown voltage of the first diode 20, the electrostatic charge is discharged from the first diode 20. When static electricity occurs between the input/output terminal and the grounding terminal and the voltage generated by the electrostatic charge is higher than the forward ON voltage of the second diode 21, the electrostatic charge is discharged from the second diode 21.

In another optional embodiment, the first voltage is the grounding voltage Vss, and the second voltage is the power supply voltage Vdd. That is, in the first diode 20, the anode is connected to the grounding terminal and the cathode is connected to the input/output terminal, and in the second diode 21, the anode is connected to the input/output terminal and the cathode is connected to the power supply terminal. Therefore, when static electricity occurs between the input/output terminal and the power supply terminal and the voltage generated by the electrostatic charge is higher than the forward ON voltage of the first diode 20, the electrostatic charge is discharged from the first diode 20. When static electricity occurs between the input/output terminal and the grounding terminal and the voltage generated by the electrostatic charge is higher than the reverse breakdown voltage of the second diode 21, the electrostatic charge is discharged from the second diode 21.

As shown in Figure 2, in one optional embodiment, a first doped region 201 in the first diode 20 is externally connected to the first voltage through a lead, the first voltage may be, for example, the grounding voltage Vss, and a second doped region 202 in the first diode 20 is externally connected to the input/output terminal (I/O terminal in the drawing) through a lead. A fourth doped region 212 in the second diode 21 is externally connected to the input/output terminal (I/O terminal in the drawing) through a lead, and a third doped region 211 in the second diode 21 is externally connected to the second voltage through a lead. The second voltage may be, for example, the power supply voltage Vdd. At the same time, the fifth doped region 22 on peripheries of the first diode 20 and the second diode 21 is externally connected to the second voltage, and a guard ring 13 on a periphery of the fifth doped region 22 is externally connected to the first voltage.

In one optional embodiment, the substrate 10 further includes a doped well region 14 of the first conductivity type and a doped well region 15 of the second conductivity type. The doped well region 14 of the first conductivity type and the doped well region 15 of the second conductivity type are located in the deep well region 12, the first diode 20 is located in the doped region of the first conductivity type, and the second diode 21 is located in the doped well region 15 of the second conductivity type. The doped well region 14 of the first conductivity type and the doped well region 15 of the second conductivity type may be formed by ion implantation on the substrate 10. The first diode 20 includes a first doped region 201 of the first conductivity type and a second doped region 202 of the second conductivity type. The first doped region 201 serves as the anode of the first diode 20, and the second doped region 202 serves as the cathode of the first diode 20. The second diode 21 includes a third doped region 211 of the second conductivity type and a fourth doped region 212 of the first conductivity type. The fourth doped region 212 serves as the anode of the second diode 21, and the third doped region 211 serves as the cathode of the second diode 21.

In one optional embodiment, the first conductivity type is P-type; that is, the doped well region 14 of the first conductivity type is a P-type doped well region. The second conductivity type is N-type; that is, the doped well region 15 of the second conductivity type is an N-type doped well region. The first diode 20 is located in the P-type doped well region. The second diode 21 is located in the N-type doped well region. The first diode 20 includes the P-type first doped region 201 and the N-type second doped region 202, the first doped region 201 and the second doped region 202 are located in the P-type doped well region, the first doped region 201 is externally connected to the first voltage, and the second doped region 202 is externally connected to an input/output voltage. The second diode 21 includes the N-type third doped region 211 and the P-type fourth doped region 212, the third doped region 211 and the fourth doped region 212 are located in the N-type doped well region, the third doped region 211 is externally connected to the second voltage, and the fourth doped region 212 is externally connected to the input/output voltage.

In one example, numbers of the P-type first doped region 201 and the N-type second doped region 202 included in the first diode 20 may be set according to an actual requirement, and may both be one or more. Similarly, numbers of the N-type third doped region 211 and the P-type fourth doped region 212 included in the second diode 21 may also be one or more. In this embodiment, the numbers of the P-type first doped region 201 and the N-type second doped region 202 included in the first diode 20 may be more than one, and the numbers of the N-type third doped region 211 and the P-type fourth doped region 212 included in the second diode 21 may also be more than one. In this way, the first diode 20 and the second diode 21 include a plurality of sub-diodes connected in parallel, thereby improving the electrostatic discharge capability of the electrostatic protection device.

In one optional embodiment, the first doped region 201 and the second doped region 202 are spaced apart in a first direction; and the third doped region 211 and the fourth doped region 212 are spaced apart in the first direction. That is, when the electrostatic protection device includes at least one first diode 20 and at least one second diode 21, the first doped regions 201 and the second doped regions 202 are spaced apart in the first direction, and the third doped regions 211 and the fourth doped regions 212 are spaced apart in the first direction.

In one optional embodiment, as shown in Figure 1, the first doped regions 201 located on two sides of one second doped region 202 are connected at two ends to form a first ring around the second doped region 202. The second doped region 202 is located in the first ring and spaced from an inner wall of the first ring, and is not in contact with the first ring. The third doped regions 211 located on two sides of one fourth doped region 212 are connected at two ends to form a second ring around the fourth doped region 212. The fourth doped region 212 is located in the second ring and spaced from an inner wall of the second ring, and is not in contact with the second ring.

In one optional embodiment, a shallow trench isolation structure 16 is arranged between the first doped region 201 and the second doped region 202, between the first doped region 201 and the third doped region 211 and between the third doped region 211 and the fourth doped region 212. That is, the shallow trench isolation structure 16 is formed between the second doped region 202 and the first ring to isolate the second doped region 202 from the first ring, and the shallow trench isolation structure 16 is formed between the fourth doped region 212 and the second ring to isolate the fourth doped region 212 from the second ring.

In one optional embodiment, the doped well region 14 of the first conductivity type is adjacent to the doped well region 15 of the second conductivity type. That is, the P-type doped region and the N-type doped region shown in Figure 2 are adjacent to each other. In this case, the first doped region 201 near the doped well region 15 of the second conductivity type is close to the third doped region 211 near the doped well region 14 of the first conductivity type, but the first doped region 201 is spaced from the third doped region 211, and the shallow trench isolation structure 16 is also formed between them. The shallow trench isolation structure 16 can isolate the first doped region 201 from the third doped region 211.

In one optional embodiment, a plurality of second doped regions 202 are included in a second direction; that is, the plurality of second doped regions 202 are spaced apart in the second direction. A plurality of fourth doped regions 212 are included in the second direction; that is, the plurality of fourth doped regions 212 are spaced apart in the second direction. The second direction may be perpendicular to the first direction. The plurality of second doped regions 202 arranged in a row in the second direction are located in the same first ring, and the plurality of fourth doped regions 212 arranged in a row in the second direction are located in the same second ring. When the plurality of second doped regions 202 arranged in a row exist in the first ring, the discharge of the electrostatic charge can be distributed evenly on each second doped region 202 in the first ring, and is relatively uniform. Similarly, when the plurality of fourth doped regions 212 arranged in a row exist in the second ring, the discharge of the electrostatic charge can be distributed evenly on each fourth doped region 212 in the second ring, and is relatively uniform.

As shown in Figure 3, in other optional embodiments, only one elongated second doped region 202 may exist in the first ring, and only one elongated fourth doped region 212 may exist in the second ring. In such embodiments, the discharge of the electrostatic charge is more concentrated, but such arrangements improve the discharge capability of the electrostatic protection device.

In one optional embodiment, the semiconductor electrostatic protection device further includes: a guard ring 13. The deep well region 12 is located in the guard ring 13, and the guard ring 13 is of the second conductivity type. The guard ring 13 may be N-type, is formed on a periphery of the deep well region 12 and surrounds the deep well region 12 and the fifth doped region 22. The guard ring 13 can prevent the movement of minority carriers inside and outside the guard ring 13, thereby reducing the interaction between a semiconductor device outside the guard ring 13 and an electrostatic protection device inside the guard ring 13.

In one optional embodiment, the first doped region 201 and the second doped region 202 are alternately spaced apart in a first direction; and the third doped region 211 and the fourth doped region 212 are alternately spaced apart in the first direction. That is, when the semiconductor electrostatic protection device includes at least two first diodes 20 and at least two second diodes 21, the first doped regions 201 and the second doped regions 202 are alternately spaced apart in the first direction so as to form a number of first diodes 20 connected in series, and the third doped regions 211 and the fourth doped regions 212 are alternately spaced apart in the first direction so as to form a number of second diodes 21 connected in series.

In one optional embodiment, the first doped region 201 defines a plurality of first rings, and the second doped region 202 is located in the first ring. The third doped region 211 defines a plurality of second rings, and the fourth doped region 212 is located in the second ring.

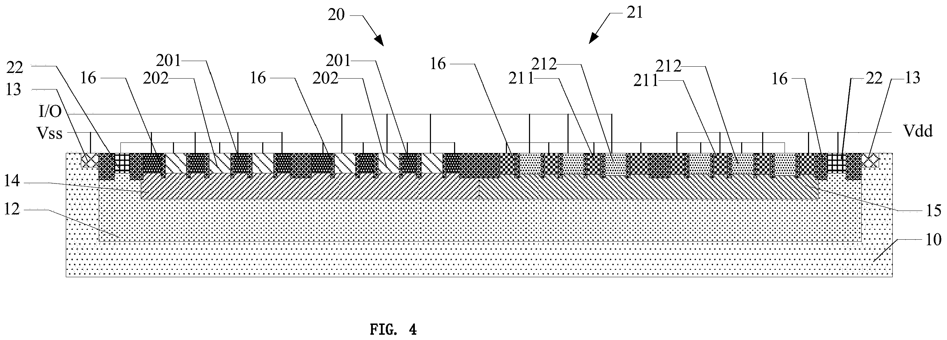

As shown in Figure 4, in one optional embodiment, at least two first diodes 20 are provided and sequentially connected in series, and two, three, or more first diodes 20 may be provided. At least two second diodes 21 are provided and sequentially connected in series, and two, three, or more second diodes 21 may be provided. However, the values are only examples in the specific embodiments, and the number of the first diode 20 and the number of the second diode 21 are not limited to the above values. Taking the first diode 20 as an example, if the semiconductor electrostatic protection device includes two first diodes 20, the two first diodes 20 are connected in series between the first voltage and the input/output voltage. Therefore, a voltage generated by the electrostatic charge turning on or reversely breaking down the two first diodes 20 is a sum of ON voltages or reverse breakdown voltages of the two first diodes 20, and the same is true for the second diode 21. The voltages connected to the anode of the first diode 20 and the cathode of the second diode 21 can be exchanged by changing the number of the first diode 20 and the number of the second diode 21. In this case, one of the first diode 20 and the second diode 21, which is connected reversely, may not be turned on during normal operation, and can be turned on only when the voltage generated by the electrostatic charge is higher than a sum of ON voltages of all diodes connected reversely. This enables the electrostatic protection device according to the present invention to clamp the voltage generated by the electrostatic charge to a sum of ON voltages of a plurality of first diodes 20.

In one optional embodiment, as shown in Figure 4, the first doped region 201 located in the first diode 20 at the leftmost end of the doped well region 14 of the first conductivity type is externally connected to the first voltage. For example, the first voltage is Vss. The second doped region 202 thereof is electrically connected to the first doped region 201 in the first diode 20 at the right end of the doped well region 14 of the first conductivity type through a lead. The second doped region 202 in the first diode 20 at the right end of the doped well region 14 of the first conductivity type is electrically connected to the I/O terminal through a lead. The fourth doped region 212 located in the second diode 21 at the left end of the doped well region 15 of the second conductivity type is electrically connected to the I/O terminal through a lead, and the third doped region 211 thereof is electrically connected to the fourth doped region 212 located in the second diode 21 at the right end of the second doped region 15. The third doped region 211 located in the second diode 21 at the right end of the second doped region 15 is externally connected to the second voltage through a lead. For example, the second voltage is Vdd. At the same time, the guard ring 13 is externally connected to the first voltage Vss, and the fifth doped region 22 is externally connected to the second voltage Vdd.

Through the above technical solutions, when the chip is exposed to an electrostatic environment, if the voltage generated by the electrostatic charge entering the input/output pin of the chip is higher than the reverse breakdown voltage or the forward ON voltage of the first diode 20 and/or the second diode 21, the electrostatic charge may be discharged through the first diode 20 and/or the second diode 21 to avoid damages to the internal circuit of the chip caused by the electrostatic charge. At the same time, since the first diode 20 and the second diode 21 are located inside the deep well region 12, the first diode 20 and the second diode 21 are isolated by the deep well region 12, which can avoid the interference with the internal circuit of the chip. Moreover, the first diode 20 and the second diode 21 have smaller parasitic capacitance, which can meet increasingly higher requirements of the dynamic random access memory for the input/output pin.

Technical features of the above embodiments may be combined randomly. To make descriptions brief, not all possible combinations of the technical features in the embodiments are described. Therefore, as long as there is no contradiction between the combinations of the technical features, they should all be considered as scopes disclosed in the specification.

The above embodiments only describe several implementations of the present invention, and their description is specific and detailed, but cannot therefore be understood as a limitation on the patent scope of the present invention. It should be noted that those of ordinary skill in the art may further make variations and improvements without departing from the conception of the present invention, and these all fall within the protection scope of the present invention. Therefore, the patent protection scope of the present invention should be subject to the appended claims.

## Claims

1. A semiconductor electrostatic protection device, comprising:
a substrate, a deep well region of a first conductivity type being formed in the substrate;
a first diode, an anode of the first diode being connected to a first voltage, and a cathode of the first diode being connected to an input/output terminal; and
a second diode, an anode of the second diode being connected to the input/output terminal, and a cathode of the second diode being connected to a second voltage;
the first diode and the second diode being located in the deep well region of the first conductivity type.

2. The semiconductor electrostatic protection device according to claim 1, further comprising: a guard ring, the deep well region being located in the guard ring, and the guard ring being of a second conductivity type.

3. The semiconductor electrostatic protection device according to claim 2, further comprising: a doped well region of the first conductivity type and a doped well region of the second conductivity type, the doped well region of the first conductivity type and the doped well region of the second conductivity type being located in the deep well region, the first diode being located in the doped region of the first conductivity type, and the second diode being located in the doped region of the second conductivity type.

4. The semiconductor electrostatic protection device according to claim 3, wherein the doped well region of the first conductivity type is adjacent to the doped well region of the second conductivity type.

5. The semiconductor electrostatic protection device according to claim 3, wherein the first diode comprises a first doped region of the first conductivity type and a second doped region of the second conductivity type, the first doped region serving as the anode of the first diode, and the second doped region serving as the cathode of the first diode; and
the second diode comprises a third doped region of the second conductivity type and a fourth doped region of the first conductivity type, the fourth doped region serving as the anode of the second diode, and the third doped region serving the cathode of the second diode.

6. The semiconductor electrostatic protection device according to claim 5, wherein the first doped region and the second doped region are alternately spaced apart in a first direction; and the third doped region and the fourth doped region are alternately spaced apart in the first direction.

7. The semiconductor electrostatic protection device according to claim 5, wherein the first doped region defines a plurality of first rings, the second doped region being located in the first ring; and the third doped region defines a plurality of second rings, the fourth doped region being located in the second ring.

8. The semiconductor electrostatic protection device according to any one of claims 5 to 7, wherein a plurality of second doped regions are spaced apart in a second direction; and a plurality of fourth doped regions are spaced apart in the second direction.

9. The semiconductor electrostatic protection device according to claim 8, wherein a shallow trench isolation structure is arranged between the first doped region and the second doped region, between the first doped region and the third doped region and between the third doped region and the fourth doped region.

10. The semiconductor electrostatic protection device according to claim 1, wherein the first voltage is a power supply voltage, and the second voltage is a grounding voltage.

11. The semiconductor electrostatic protection device according to claim 1, wherein the first voltage is a grounding voltage, and the second voltage is a power supply voltage.

12. The semiconductor electrostatic protection device according to claim 1, wherein at least two first diodes are provided and sequentially connected in series; and
at least two second diodes are provided and sequentially connected in series.

13. The semiconductor electrostatic protection device according to claim 1, wherein the substrate is made of silicon, germanium, gallium arsenide (GaAs), indium phosphide (InP) or gallium nitride (GaN).

14. The semiconductor electrostatic protection device according to claim 5, wherein a fifth doped region is formed in the deep well region, the fifth doped region being of the first conductivity type, and the fifth doped region serving as a pickup region of the deep well region; and the fifth doped region being in a shape of a ring, and the first diode and the second doped region being located in the ring formed by the fifth doped region.

15. The semiconductor electrostatic protection device according to claim 14, further comprising:
a guard ring, the deep well region being located in the guard ring, the guard ring being of the second conductivity type, and the guard ring being formed on a periphery of the deep well region and surrounding the deep well region and the fifth doped region.

16. The semiconductor electrostatic protection device according to claim 1, wherein the first voltage is a power supply voltage, the second voltage is a grounding voltage, the anode of the first diode is connected to a power supply terminal, the cathode of the first diode is connected to the input/output terminal, the anode of the second diode is connected to the input/output terminal, and the cathode of the second diode is connected to a grounding terminal.

17. The semiconductor electrostatic protection device according to claim 1, wherein the first voltage is a grounding voltage, the second voltage is a power supply voltage, the anode of the first diode is connected to a grounding terminal, the cathode of the first diode is connected to the input/output terminal, the anode of the second diode is connected to the input/output terminal, and the cathode of the second diode is connected to a power supply terminal.

18. The semiconductor electrostatic protection device according to claim 15, wherein the first doped region in the first diode is externally connected to the first voltage through a lead, and the second doped region in the first diode is externally connected to the input/output terminal through a lead; the fourth doped region in the second diode is externally connected to the input/output terminal through a lead, and the third doped region in the second diode is externally connected to the second voltage through a lead; and the fifth doped region on peripheries of the first diode and the second diode is externally connected to the second voltage, and the guard ring on a periphery of the fifth doped region is externally connected to the first voltage.

19. The semiconductor electrostatic protection device according to claim 7, wherein the first conductivity type is P-type, the doped well region is a P-type doped well region, the second conductivity type is N-type, the doped well region of the second conductivity type is an N-type doped well region, the first diode is located in the P-type doped well region, and the second diode is located in the N-type doped well region;
the first diode comprises the P-type first doped region and the N-type second doped region, the first doped region and the second doped region are located in the P-type doped well region, the first doped region is externally connected to the first voltage, and the second doped region is externally connected to an input/output voltage; and
the second diode comprises the N-type third doped region and the P-type fourth doped region, the third doped region and the fourth doped region are located in the N-type doped well region, the third doped region is externally connected to the second voltage, and the fourth doped region is externally connected to the input/output voltage.

20. The semiconductor electrostatic protection device according to claim 18, wherein only one elongated second doped region exists in the first ring, and only one elongated fourth doped region exists in the second ring.
